# EUROPEAN PATENT SPECIFICATION

(11) **EP 1 915 482 B1**
(45) Date of publication and mention of the grant of the patent: **09.01.2019**
(21) Application number: 06765041.6
(22) Date of filing: 20.07.2006
(51) Int. Cl.: D21H 21/44, B42D 15/00

(54) **SECURITY DEVICES FOR SECURITY SUBSTRATES**
SICHERHEITSVORRICHTUNGEN FÜR SICHERHEITSSUBSTRATE
DISPOSITIFS DE SECURITE DESTINES A DES SUBSTRATS DE SECURITE

(30) Priority: 15.08.2005 GB 0516724
(43) Date of publication of application: 30.04.2008
(73) Proprietor: De La Rue International Limited, Basingstoke, Hampshire RG22 4BS (GB)
(72) Inventor: COMMANDER, Lawrence George, Reading Berkshire RG31 6RR (GB)
(74) Representative: Boult Wade Tennant LLP
(86) International application number: PCT/GB2006/002711
(87) International publication number: WO 2007/020370

(56) References cited:
- WO-A-2004/049353
- WO-A-2004/062943
- US-A- 5 688 587
- US-A1- 2003 106 943

## Description

The invention relates to a security device for security substrates, such as paper, used for making security documents, such as bank notes, having anti-counterfeitable features.

It is generally known to include elongate elements in paper or other substrates, usually as a security feature. Such elements can be threads, strips or ribbons of, for example, plastics film, metal foil, metallised plastic, metal wire. These elongate elements are included in the thickness of the substrate to render imitation of documents produced therefrom more difficult. These elements help in the verification of the documents as they render the view of the documents in reflected light different from that in transmitted light. To increase the security provided by the inclusion of such an elongate element, it is also known to endow the element itself with one or more verifiable properties over and above its presence or absence. Such additional properties include magnetic properties, electrical conductivities, the ability to absorb x-rays, fluorescence, optically variable effects and thermochromic behaviour.

As a further security feature, it has been found to be particularly advantageous to provide windows in one side of the surface of the substrate, which expose such elongate elements at spaced locations. Examples of methods of manufacturing paper incorporating security elements with or without windows are described below. It should be noted that references to "windowed thread paper" include windowed paper incorporating any elongate security element.

EP-A-0059056 describes a method of manufacture of windowed thread paper on a cylinder mould paper-making machine. The technique involves embossing the cylinder mould cover to form raised regions and bringing an impermeable elongate security element into contact with the raised regions of the mould cover, prior to the contact entry point into a vat of aqueous paper stock. Where the impermeable security element makes intimate contact with the raised regions of the embossing, no fibre deposition can occur and windows are formed in the surface of the paper. After the paper is fully formed and couched from the cylinder mould cover, water is extracted from the wet fibre mat and the paper is passed through a drying process. In the finished paper the regions of the security element which are exposed in the windows are visible in reflected light on one side of the paper, which is commonly used for mainly banknotes.

As an alternative to elongate elements, patches and foils can be applied to a surface of a substrate to cover a window or aperture.

The widespread use of security documents having security elements exposed on windows along the length of the element has resulted in enhanced security. A security document of this type provides this enhancement as, when viewed in transmitted light, the security element provides a different view from that which is seen under reflected light, where parts of the security element are readily visible in the window. However, there is a continual need for further enhanced security features to render the task of a would be counterfeiter more difficult.

US-A-5573639 describes a safeguarding thread in which metallic stripes are provided on a transparent or translucent plastic substrate. Visually and/or machine readable information extends over several of the stripes and is made up of metal free or partly metal free characters having a contrasting appearance to the metal stripes.

EP-A-0659587 also describes a security element which has a first information portion which is visually recognisable without aids and a second information portion which is harder to resolve visually due to its smaller size as compared to the first information portion. Effectively the design contains two sets of demetallised indicia, one significantly smaller than the other. A security element of this type therefore provides two levels of authentication and the fact that the two designs are visually similar increases the security.

It is an object of the present invention to further enhance the security of security devices such as elongate security elements, foils and particles.

According to the invention there is provided a security device as defined in the appended claims.

The invention provides an improvement in the anti-counterfeitability of the security devices over the construction described in EP-A-659587 in that it introduces complex requirements of positioning and registration of the smaller indicia to enable the larger indicia to be visualised. In addition, as the smaller indicia are used to create the larger indicia, the overall design takes up less space on the security element than on the prior art threads, where the smaller and larger construction portions are in separate locations. This is particularly important for windowed security devices where design space is limited to the window region.

The present invention also allows the controlled use of a limited set of characters, such as a bank's initials or note dominations, which can be laid out on a security device such that even when the vertical position is not registered, there is the ability to have a full set of characters falling within a window space on each banknote. This improves the readability of the security feature as it is given a uniform background. Such a set of characters can then combine both macro- and micro- elements in the limited space compared to the prior art devices.

An additional advantage is that the invention presents a visual image which is more interesting than those of the prior art. Making the security element interesting to the viewer increases the probability that a member of the public will view and inspect the device, and the security document as a whole, which means that the security device has a greater security impact. This has a benefit over visually complex devices, such as those described in US-A-5573639, which very easily become confusing, particularly when the document in which the security device is incorporated is overprinted. Due to the manner in which the images are built up in the present invention, this is not a problem and the large characters remain easily visible.

With the improvements in modern scanners and desk-top printing equipment, it is also necessary for manufacturers to increase the complexity of designs used on security documents, but this must be done without compromising the public accessibility or the readability of the security features. The present invention provides a simple to recognise public security feature, with a more complex feature, which is much harder to copy with modern scanning equipment.

The invention will now be described, by way of example only, with reference to, and as shown in the accompanying drawings in which:-
Figure 1 is a plan view of an elongate security element according to the present invention having metallised indicia;
Figures 2, 3, 5, 6, and 7 to 11 are plan views of alternative embodiments of the present invention, in which the security device is provided with different forms of indicia;
Figures 4 is a plan view of a security article incorporating the security device of Figure 3; and
Figure 12 is yet another alternative embodiment of the security device according to the invention wherein the indicia are of different sizes.

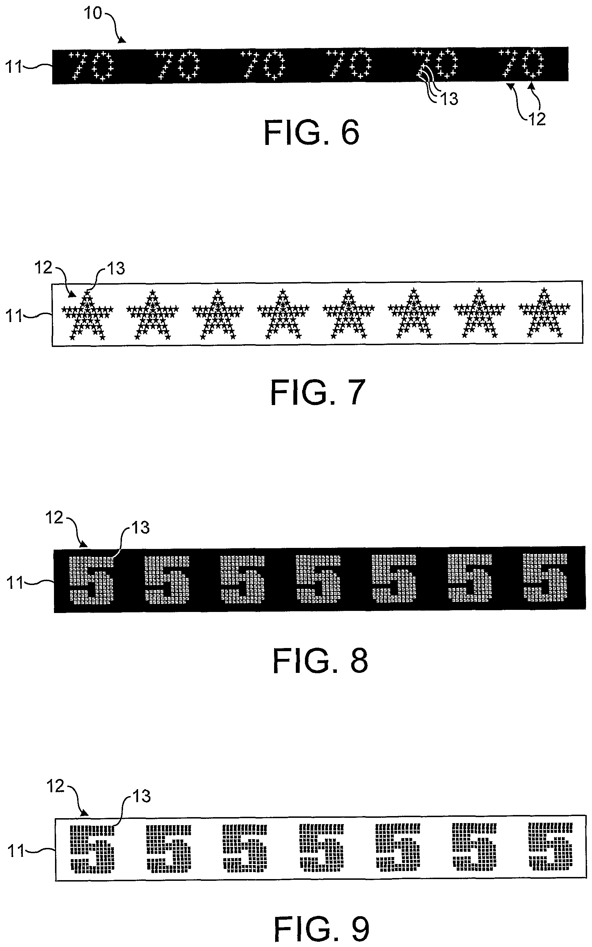

The embodiments shown in figures 7-11 are not within the scope of the invention.

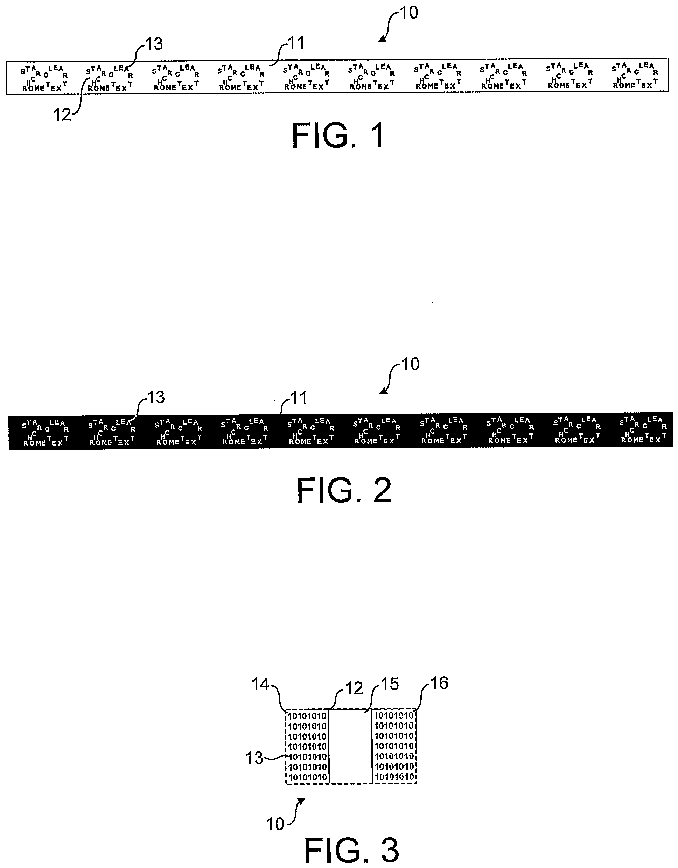

Figure 1 shows a security device in the form of an elongate security element 10 according to a first embodiment of the present invention for partially embedding into a fibrous substrate, such as security paper. The security element 10 comprises a carrier 11 of a suitable plastic material which is flexible and water impermeable, and which is at least translucent and partially light transmissive, but preferably substantially transparent. A suitable material would be PET. The security element 10 is provided with large easily legible indicia 12 which are formed from smaller indicia 13.

In the example shown in Figure 1, the large indicia 12 comprise the numerals "2" and "0" forming the number "20", wherein the "2" and "0" are constructed from the small, less easily legible metallised letters 13 which read in sequence "STARCHROME" and "CLEARTEXT". The small indicia 13 are of a size which is more difficult to discern visually by the unaided eye, but which provides an additional degree of anti-counterfeitability as they are significantly more difficult for the counterfeiter to produce. However, once the eye has focused on the large text, it becomes easier to realise the presence of the small indicia 13 and to recognise them. The smaller indicia 13 may be provided by printed, conductive or non-conductive, metallic or other opaque inks or by other known metallisation or demetallisation processes.

Preferably, the width of the security element 10 is in the range of 1 to 30mm whilst the height of the larger indicia 12 is in the range of 0.8 to 28.0mm, and more preferably 0.8 to 8.0mm. The height of the smaller indicia 13 is preferably in the range of 0.2 to 6mm and more preferably 0.2 to 2.00mm.

In a preferred embodiment, for a security element of 8mm width, the height of the large indicia 12 is preferably 6mm, with the height of the smaller indicia 13 being 1mm. For a security element of 4mm width, the height of the large indicia 12 is 2mm and the height of the smaller indicia 13 is 0.4mm. The smaller indicia 13 can be of a size where they can only be resolved by a viewing aid such as a magnifying glass.

As shown in Figure 2, the smaller indicia 13 may alternatively comprise demetallised indicia. In this example the carrier 11 is metallised to provide a metal layer of aluminium or another suitable metal. This can be done by vacuum deposition, electroplating or another suitable method. The metallised carrier 11 is then partially demetallised using a known method, such as the resist and etch method, to provide clear regions which form the indicia 13. The indicia may be formed from regions of reduced metal thickness, as described in WO 2004/014665.

In both of the embodiments shown in Figures 1 and 2, the metallic regions may be provided by printing the security element 10 with a metal effect ink having a metallic appearance such as Metalstar® inks sold by Eckart. Such metal effect inks do not, however, necessarily provide conductivity. It is advantageous, however, that the indicia 12/13, where these comprise metallic material, and/or the security element 10 as a whole, provide conductive properties that enable the thread to be machine detectable for authentication or denomination sorting purposes.

In the current invention only the small indicia are physically produced during the metallisation, demetallisation or printing process. The larger indicia are created by the positioning and registration of the smaller indicia. Generating a conventional metallic security thread with large and small demetallised characters cab be problematic because of the large difference in stem width between the large and small characters. It is difficult to optimise the etchant process to efficiently achieve both fine and coarse demetallised regions. For example, if the process is optimised for the fine regions then the coarse regions will not be completely demetallised, and if the machine is optimised for the coarse regions, then the resolution of the fine regions is reduced due to too much metal being removed. An advantage of the current invention is that as the smaller indicia are used to define the larger indicia the demetallisation process can be optimised for the stem width of the smaller characters and therefore the optimum resolution can be achieved. The demetallisation process can be further optimised by generating the small characters with a constant stem width.

As a further alternative the indicia can be provided by printing the security element 10 with an optically variable ink, such as OVI® as supplied by Sicpa, or other coloured opaque or transparent inks. One or more colours may be used to create multicoloured designs, such as national flags. In the embodiment shown in Figure 3, the first indicia 12 comprise the French flag. A first section 14 is printed with the second indicia 13, namely small numerals representing the denomination of a banknote (e.g. £10) which are printed in red ink. A second section 15 is left clear, so that the white colour of the underlying paper shows it through and a third section 16 is printed with similar numerals to those in section 14, but in blue ink. The outline is shown for the sake of clarity and is not part of the design.

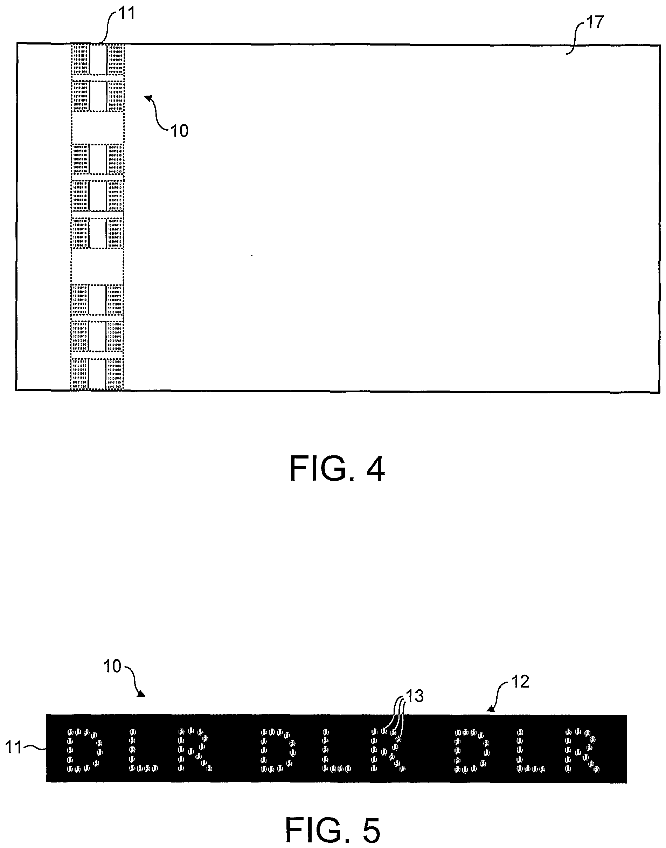

In Figure 4 the security device 10 of Figure 3 is shown as an elongate security element which is partially embedded in a security substrate from which a banknote or other security article 17 is formed, The security element is partially exposed at windows at the surface of the substrate.

Obviously any of the above mentioned inks can be combined either with other inks or with vacuum deposited metal layers.

As shown in Figures 5 and 6, symbols or pictorial elements may be used as the smaller indicia 13 instead of alphanumeric characters, which make up the alphanumeric large indicia 12 in those figures "DLR" and "70" respectively.

Figure 7 shows a further example whereby the smaller indicia 13 comprise positive opaque symbols, such as stars, this time making up the larger indicia 12, which is also a symbol of a larger star 12. The carrier 11 is clear so the indicia 12/13 will be seen as a positive design on a clear background. Figures 8 and 9 are further embodiments whereby the large indicia 12 are numerals "5", made up of smaller indicia 13 which are also the numerals "5". In Figure 8, the large indicia 12 would appear as negative metallised characters, made up of smaller indicia 13 which are negative demetallised characters formed on a metallised carrier 11. In Figure 9, similar to Figure 7, the large indicia 12 would appear positive, being made up of smaller indicia 13 which are positive metallised characters on a clear carrier 11.

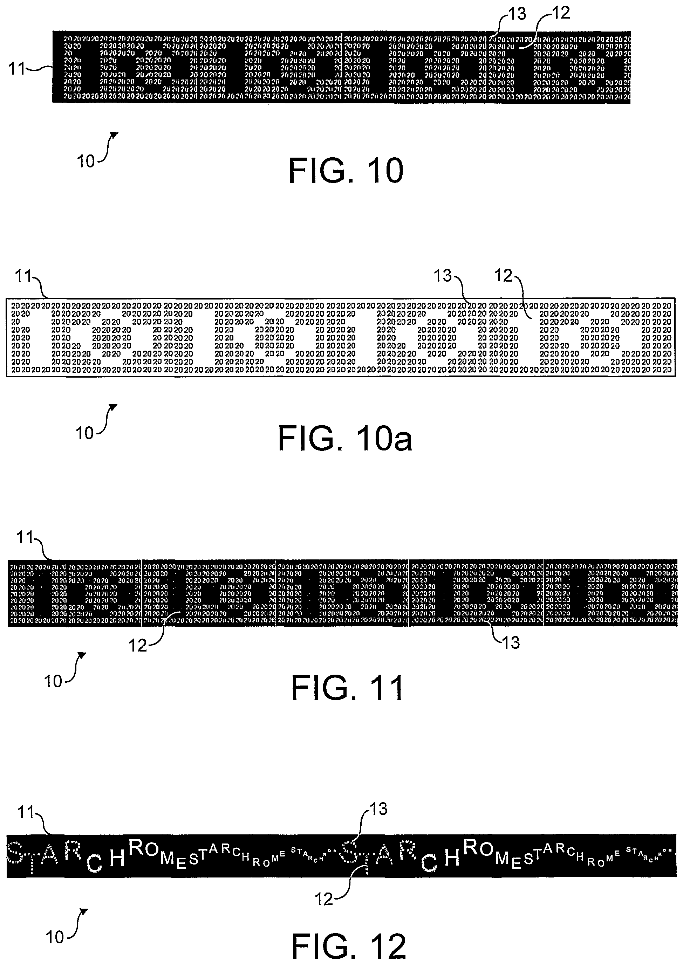

Figure 10 shows a further alternative embodiment of a security device according to the invention. In this embodiment the carrier 11 is metallised and then partially demetallised to form repeating smaller indicia 13 (the numerals "20") which closely repeat along the length and across the width of the security element 10. The larger indicia 12 are provided by solid metal regions (forming the numerals "10") outlined by a plurality of the smaller indicia 13.

In Figure 10 the large indicia 12 would appear positive, being made up of smaller negative indicia 13. Figure 10a shows a further alternative embodiment in which the smaller indicia 13 are metallised characters on a clear carrier 11. The larger indicia 12 are provided by regions of the clear carrier 11 outlined by a plurality of the smaller metallised indicia 13. In figure 10a the large indicia 12 would appear negative, being made up of smaller positive indicia 13.

Figure 11 shows an embodiment of a security device similar to that shown in figure 10, which has been modified such that smaller indicia 13 are provided along and across the entire security element 10. However, the large indicia 12 are created by modifying the appearance of the smaller indicia 13 to provide a visible contrast. For example the font or stem width of indicia 13 may be changed. Alternatively the density of the metal used in forming the smaller indicia 13 may be changed to provide the contrast for example by chemical etching to remove some but not all of the metal present in the regions of the said indicia 13. In a further embodiment, the colour of the smaller indicia may be changed to provide the contrast.

In a further alternative embodiment of the invention in which the sizes of both the smaller indicia 13 and the large indicia 12 on the security device vary along the length of a security element 10. In the embodiment illustrated in Figure 12 the size of the indicia 12,13 reduces over a first length of the element 10 from a starting size to a finishing size until a point is reached whereby the larger indicia 13 are replaced by single line indicia of a size a little smaller than the finishing size of the larger indicia 12. The single line indicia continue reducing in size over a second length of the element 10 until they nearly reach the starting size of the smaller indicia 13. At this point a further first length of larger and smaller indicia 12,13 commences. The first and second lengths appear to merge into each other. In further examples in the invention, either the size of the large indicia 12 may vary or the size of the smaller indicia 13, but not both.

A further variation on the embodiments described previously is to provide the device 10 with an optical effect layer. Examples of suitable optical effect layers include liquid crystal polymers, liquid crystal pigmented ink layers, iridescent print layers, dielectric thin film structures.

The optical effect layer may be used in addition to or instead of a demetallised layer. For example, an iridescent or liquid crystal pigmented ink layer can be printed to define the large and small indicia 12/13. More preferably the large and small indicia 12/13 are defined by printing a darkly coloured ink layer that can contain other functional pigments such as carbon black or magnetics, which is then overprinted all-over with the iridescent or liquid crystal ink layer.

Where a polymer liquid crystal film layer, holographic layer or thin film dielectric structure is applied this is preferably, but not necessarily, done in conjunction with a metal layer. For example, where the security device 10 is to be provided with a holographic layer, the demetallised layer can be used as a reflection-enhancing layer. A polymer carrier 11 is first coated with an embossing lacquer which is then embossed with a holographic relief. The embossed layer is then metallised and the resulting metal layer partially demetallised. The resulting structure can be provided with an optional protective layer

In an alternative holographic embodiment, a polymer film 11 is coated with an embossing lacquer and then embossed with a holographic relief structure. A transparent high refractive index layer (e.g. ZnS)is coated over the holographic relief layer. The large and small indicia are then provided by printing opaque or transparent inks. The ink may be a metal effect ink.

In a further alternative embodiment, a holographic transfer construction may be used. This is essentially the same as described above, but with the addition of a wax release layer and an adhesive layer. The wax release layer is provided between the polymer carrier 11 and the metal or lacquer layer such that after transfer the polymer can be removed. A hot melt or pressure sensitive adhesive layer is provided on the opposite surface to the carrier 11, i.e the surface that comes into contact with the substrate.

In a further variation thermochromic and liquid crystal materials can be used, such as those described in EP-A-608078 and WO-A-03061980.

It is also widely known, in the field of manufacturing security devices 10, to provide additional machine readable features. Machine readable properties typical to this class of security device 10 are conductivity, magnetism, and luminescence. Numerous methods have been described within the prior art for producing security devices with machine readable characteristics. Examples of such devices can be found in EP-A-319517, EP-A-516790, EP-A-998396, EP-A-961996 and EP-A-1334844.

Where the security devices are security elements, they may be inserted into a paper, or other, substrate so that they are either wholly or partially embedded within the substrate. Whilst security elements can be used in wholly embedded or windowed form, the latter is preferred as the indicia are then easily recognisable in both reflected and transmitted light, rather than in just transmitted light as in the wholly embedded form. The security elements 10 of the present invention may also be used in the construction such as those described in EP-A-1141480 whereby the element is exposed in windows on one surface of the substrate and the element is wholly exposed along its length on the other side.

In other embodiments, instead of elongate security elements, patches, foils and the like may be applied to a surface of the substrate. These may be applied such that they cover windows or apertures formed during the manufacture of the substrate or in a subsequent cutting process, such as laser or die cutting, so that part of the device is revealed on one side of the substrate in those windows or apertures.

The indicia or repeating pattern may be registered with the windows in the machine direction, so that an identical portion of the indicia or pattern is seen in each window. This requires the use of a registration process, such as that described co-pending application GB 0409736.6.

The finished security paper may be printed on one or both sides to identify the article or document formed from the paper. This printing may include indicia which matches the indicia 12 or 13.

The security substrate is used to manufacture security articles such as banknotes, vouchers, bonds, passports, security labels, certificates and the like.

## Claims

1. A security device (10) for a security substrate comprising a carrier (11) of an at least partially light transmitting polymeric material, said carrier (11) bearing a plurality of first indicia (12), said first indicia (12) being defined by a plurality of smaller second indicia (13) positioned relative to each other so as to enable the first indicia (12) to be visualised, the first indicia (12) having a height in the range of 0.8 mm to 28.0 mm and the second indicia (13) have a height in the range of 0.2 mm to 2.0mm and in that the first and second indicia (12, 13) comprise alphabetic or numeric characters, symbols or pictorial elements, and in that the first and second indicia (12, 13) are both positive indicia or are both negative indicia, and in that each of the first indicia (12) comprises a plurality of individual elements, **characterised in that** each element of each first indicia (12) is formed from a plurality of second indicia (13).

2. A security device (10) as claimed in claim 1 in which the height of the first indicia (12) is in the region of 0.8mm to 8.0mm.

3. A security device (10) as claimed in any one of the preceding claims in which the indicia (12, 13) has a constant stem width.

4. A security device (10) as claimed in any one of the preceding claims in which the first indicia (12) are defined by at least two sets of second indicia (13), in which a characteristic of one set of second indicia (13) varies with respect to a second set of second indicia (13).

5. A security device (10) as claimed in claim 4 in which the varying characteristic is stem width.

6. A security device (10) as claimed in claim 4 in which the varying characteristic is font.

7. A security device (10) as claimed in claim 4 in which the varying characteristic is density or thickness of the material forming the indicia (12, 13).

8. A security device (10) as claimed in claim 4 in which the varying characteristic is colour.

9. A security device (10) as claimed in any one of the preceding claims in which the first and second indicia (12, 13) comprise the same visual information.

10. A security device (10) as claimed in any one of the preceding claims in which the indicia (12, 13) are formed using printing ink.

11. A security device (10) as claimed in any one of claims 1 to 9 in which the indicia (12, 13) are formed using a metallic or metal effect printing ink.

12. A security device (10) as claimed in any one of claims 1 to 9 in which the indicia (12, 13) are defined by metal deposits.

13. A security device (10) as claimed in claim 12 in which the indicia (12, 13) are formed from regions of reduced metal thickness in a metallised layer.

14. A security device (10) as claimed in any one of the preceding claims in which the size of the larger indicia (13) varies.

15. A security device (10) as claimed in any one of the preceding claims in which the size of the smaller indicia (12) varies.

16. A security device (10) as claimed in claim 14 and claim 15 in which the sizes of both the smaller and the larger indicia (12,13) vary.

17. A security device (10) as claimed in claim 16 in which the smaller and larger indicia (12, 13) each have a starting size, from which the size of both sets of indicia (12, 13) reduces to a finishing size over a first length, further comprising a set of intermediate indicia formed from single lines, which intermediate indicia reduce from a starting size smaller than the finishing size of the larger indicia to a finishing size larger than the starting size of the smaller indicia over a second length, a second length of said intermediate indicia being located between two first lengths.

18. A security substrate comprising a security device (10) as claimed in any one of the preceding claims.

19. A security substrate as claimed in claim 18 in which the security device (10) is wholly or partially embedded in the substrate.

20. A security substrate as claimed in claim 19 comprising windows in at least one surface of the substrate at which are exposed regions of the security device (10).

21. A security substrate as claimed in claim 18 in which the security device (10) is applied to a surface of the substrate.

22. A security substrate as claimed in claim 18 in which the security device (10) covers an aperture or window in the substrate.

23. A security substrate as claimed in any one of claims 18 to 22 wherein the substrate is paper.

24. A security article (17) formed from the substrate of any one of claims 18 to 23 comprising printing on at least one surface of the security substrate.

25. A security article (17) as claimed in claim 24 in which the printing on the surface of the security substrate comprises indicia which is the same as the first indicia and/or second indicia (12, 13) on the security element (10).

26. A security article (17) as claimed in any one of the claims 24 or 25 comprising a banknote, voucher, bond, passport, security label, certificate and the like.

## Patentansprüche

1. Sicherheitsvorrichtung (10) für ein Sicherheitssubstrat, umfassend einen Träger (11) aus einem zumindest teilweise lichtdurchlässigen Polymermaterial, wo wobei Träger (11) eine Vielzahl von ersten Zeichen (12) trägt, wobei die ersten Zeichen (12) durch eine Vielzahl von kleineren zweiten Zeichen (13), die relativ zueinander so positioniert sind, dass sich die ersten Zeichen (12) visualisieren lassen, wobei die ersten Zeichen (12) eine Höhe im Bereich von 0,8 mm bis 28,0 mm aufweisen und die zweiten Zeichen (13) eine Höhe im Bereich von 0,2 mm bis 2,0 mm aufweisen, und dadurch dass die ersten und zweiten Zeichen (12, 13) alphabetische oder numerische Zeichen, Symbole oder Bildelemente umfassen, und dadurch dass die ersten und zweiten Zeichen (12, 13) beide positive Zeichen sind oder beide negative Zeichen sind, und dadurch dass jedes der ersten Zeichen (12) eine Vielzahl von Einzelelementen umfasst, definiert sind, **dadurch gekennzeichnet, dass** jedes Element jedes ersten Zeichens (12) aus einer Vielzahl von zweiten Zeichen (13) gebildet ist.

2. Sicherheitsvorrichtung (10) nach Anspruch 1, wobei die Höhe der ersten Zeichen (12) im Bereich von 0,8 mm bis 8,0 mm liegt.

3. Sicherheitsvorrichtung (10) nach einem der vorangehenden Ansprüche, wobei die Zeichen (12, 13) eine konstante Stammbreite aufweisen.

4. Sicherheitsvorrichtung (10) nach einem der vorangehenden Ansprüche, wobei die ersten Zeichen (12) durch mindestens zwei Sätze von zweiten Zeichen (13) definiert sind, wobei ein Merkmal eines Satzes von zweiten Zeichen (13) in Bezug auf einen zweiten Satz von zweiten Zeichen (13) variiert.

5. Sicherheitsvorrichtung (10) nach Anspruch 4, wobei die unterschiedliche Eigenschaft die Stammbreite ist.

6. Sicherheitsvorrichtung (10) nach Anspruch 4, wobei die unterschiedliche Eigenschaft eine Schrift ist.

7. Sicherheitsvorrichtung (10) nach Anspruch 4, wobei die variierende Eigenschaft die Dichte oder Dicke des die Zeichen (12, 13) bildenden Materials ist.

8. Sicherheitsvorrichtung (10) nach Anspruch 4, wobei die unterschiedliche Eigenschaft die Farbe ist.

9. Sicherheitsvorrichtung (10) nach einem der vorangehenden Ansprüche, wobei erste und zweite Zeichen (12, 13) die gleichen visuellen Informationen umfassen.

10. Sicherheitsvorrichtung (10) nach einem der vorangehenden Ansprüche, wobei die Zeichen (12, 13) unter Verwendung von Druckfarbe gebildet werden.

11. Sicherheitsvorrichtung (10) nach einem der Ansprüche 1 bis 9, wobei die Zeichen (12, 13) unter Verwendung einer Metall- oder Metalleffekt-Druckfarbe gebildet werden.

12. Sicherheitsvorrichtung (10) nach einem der Ansprüche 1 bis 9, wobei die Zeichen (12, 13) durch Metallablagerungen definiert sind.

13. Sicherheitsvorrichtung (10) nach Anspruch 12, wobei die Zeichen (12, 13) aus Bereichen mit reduzierter Metalldicke in einer metallisierten Schicht gebildet sind.

14. Sicherheitsvorrichtung (10 nach einem der vorangehenden Ansprüche, wobei die Größe der größeren Zeichen (13) variiert.

15. Sicherheitsvorrichtung (10 nach einem der vorangehenden Ansprüche, wobei die Größe der kleineren Zeichen (12) variiert.

16. Sicherheitsvorrichtung (10) nach Anspruch 14 und Anspruch 15, wobei die Größen sowohl der kleineren als auch der größeren Zeichen (12, 13) variieren.

17. Sicherheitsvorrichtung (10) nach Anspruch 16, wobei die kleineren und größeren Zeichen (12, 13) jeweils eine Ausgangsgröße aufweisen, von der aus sich die Größe beider Zeichensätze (12, 13) über eine erste Länge auf eine Endgröße reduziert, ferner umfassend einen Satz von Zwischenzeichen, die aus einzelnen Linien gebildet sind, wobei die Zwischenzeichen von einer Ausgangsgröße, die kleiner als die Endgröße der größeren Zeichen ist, auf eine Endgröße reduziert werden, die größer als die Ausgangsgröße der kleineren Zeichen über eine zweite Länge ist, wobei eine zweite Länge der Zwischenzeichen zwischen zwei ersten Längen liegt.

18. Sicherheitssubstrat, umfassend eine Sicherheitsvorrichtung (10) nach einem der vorangehenden Ansprüche.

19. Sicherheitssubstrat nach Anspruch 18, wobei die Sicherheitsvorrichtung (10) ganz oder teilweise in das Substrat eingebettet ist.

20. Sicherheitssubstrat nach Anspruch 19, umfassend Fenster in mindestens einer Oberfläche des Substrats, an der sich freiliegende Bereiche der Sicherheitsvorrichtung (10) befinden.

21. Sicherheitssubstrat nach Anspruch 18, wobei die Sicherheitsvorrichtung (10) auf eine Oberfläche des Substrats aufgebracht ist.

22. Sicherheitssubstrat nach Anspruch 18, wobei die Sicherheitsvorrichtung (10) eine Öffnung oder ein Fenster in dem Substrat abdeckt.

23. Sicherheitssubstrat nach einem der Ansprüche 18 bis 22, wobei das Substrat Papier ist.

24. Sicherheitsartikel (17), der aus dem Substrat nach einem der Ansprüche 18 bis 23 gebildet ist, umfassend das Drucken auf mindestens eine Oberfläche des Sicherheitssubstrats.

25. Sicherheitsartikel (17) nach Anspruch 24, wobei der Druck auf die Oberfläche des Sicherheitssubstrats Zeichen umfasst, die mit den ersten Zeichen und/oder zweiten Zeichen (12, 13) auf dem Sicherheitselement (10) identisch sind.

26. Sicherheitsartikel (17) nach einem der 5 Ansprüche 24 oder 25, umfassend eine Banknote, einen Beleg, eine Kaution, einen Reisepass, ein Sicherheitsetikett, ein Zertifikat und dergleichen.

## Revendications

1. Dispositif de sécurité (10) pour un substrat de sécurité comprenant un support (11) en un matériau polymère transmettant au moins partiellement la lumière, ledit support (11) supportant une pluralité de premiers indices (12), lesdits premiers indices (12) étant définis par une pluralité de seconds indices plus petits (13) positionnés les uns par rapport aux autres de sorte à permettre aux premiers indices (12) d'être visualisés, les premiers indices (12) ayant une hauteur dans la plage de 0,8 mm à 28,0 mm et les seconds indices (13) ayant une hauteur dans la plage de 0,2 mm à 2,0 mm et en ce que les premiers et seconds indices (12, 13) comprennent des caractères alphabétiques ou numériques, des symboles ou éléments picturaux, et en ce que les premiers et seconds indices (12, 13) sont tous des indices positifs ou sont tous des indices négatifs, et en ce que chacun des premiers indices (12) comprend une pluralité d'éléments individuels, **caractérisé en ce que** chaque élément de chaque premier indice (12) est formé d'une pluralité de seconds indices (13).

2. Dispositif de sécurité (10) selon la revendication 1, dans lequel la hauteur des premiers indices (12) est dans la région de 0,8 mm à 8,0 mm.

3. Dispositif de sécurité (10) selon l'une quelconque des revendications précédentes, dans lequel les indices (12, 13) ont une largeur de tige constante.

4. Dispositif de sécurité (10) selon l'une quelconque des revendications précédentes, dans lequel les premiers indices (12) sont définis par au moins deux ensembles de seconds indices (13), dans lequel une caractéristique d'un ensemble de seconds indices (13) varie par rapport à un second ensemble de seconds indices (13).

5. Dispositif de sécurité (10) selon la revendication 4, dans lequel la caractéristique variable est la largeur de tige.

6. Dispositif de sécurité (10) selon la revendication 4, dans lequel la caractéristique variable est la police.

7. Dispositif de sécurité (10) selon la revendication 4, dans lequel la caractéristique variable est la densité ou l'épaisseur du matériau formant les indices (12, 13).

8. Dispositif de sécurité (10) selon la revendication 4, dans lequel la caractéristique variable est la couleur.

9. Dispositif de sécurité (10) selon l'une quelconque des revendications précédentes, dans lequel les premiers et seconds indices (12, 13) comprennent les mêmes informations visuelles.

10. Dispositif de sécurité (10) selon l'une quelconque des revendications précédentes, dans lequel les indices (12, 13) sont formés au moyen d'encre d'impression.

11. Dispositif de sécurité (10) selon l'une quelconque des revendications 1 à 9, dans lequel les indices (12, 13) sont formés au moyen d'encre métallique ou à effet métallique.

12. Dispositif de sécurité (10) selon l'une quelconque des revendications 1 à 9, dans lequel les indices (12, 13) sont définis par des dépôts de métal.

13. Dispositif de sécurité (10) selon la revendication 12, dans lequel les indices (12, 13) sont formés à partir de régions d'épaisseur de métal réduite dans une couche métallisée.

14. Dispositif de sécurité (10) selon l'une quelconque des revendications précédentes, dans lequel la taille des indices plus grands (13) varie.

15. Dispositif de sécurité (10) selon l'une quelconque des revendications précédentes, dans lequel la taille des indices plus petits (12) varie.

16. Dispositif de sécurité (10) selon la revendication 14 ou la revendication 15, dans lequel les tailles d'à la fois les indices plus petits et plus grands (12, 13) varient.

17. Dispositif de sécurité (10) selon la revendication 16, dans lequel les indices plus petits et plus grands (12, 13) ont chacun une taille de départ, à partir de laquelle la taille des deux ensembles d'indices (12, 13) se réduit jusqu'à une taille de finition sur une premier longueur, comprenant un ensemble d'indices intermédiaires formés à partir de lignes simples, lesquels indices intermédiaires se réduisent d'une taille de départ plus petite que la taille de finition des indices plus grands jusqu'à une taille de finition plus grande que la taille de départ des indices plus petits sur une seconde longueur, une seconde longueur desdits indices intermédiaires étant située entre deux premières longueurs.

18. Substrat de sécurité comprenant un dispositif de sécurité (10) selon l'une quelconque des revendications précédentes.

19. Substrat de sécurité selon la revendication 18, dans lequel le dispositif de sécurité (10) est complètement ou partiellement logé dans le substrat.

20. Substrat de sécurité selon la revendication 19, comprenant des fenêtres dans au moins une surface du substrat au niveau desquelles sont exposées des régions du dispositif de sécurité (10).

21. Substrat de sécurité selon la revendication 18, dans lequel le dispositif de sécurité (10) est appliqué à une surface du substrat.

22. Substrat de sécurité selon la revendication 18, dans lequel le dispositif de sécurité (10) couvre une ouverture ou fenêtre dans le substrat.

23. Substrat de sécurité selon l'une quelconque des revendications 18 à 22, dans lequel le substrat est du papier.

24. Dispositif de sécurité (17) formé à partir du substrat selon l'une quelconque des revendications 18 à 23, comprenant une impression sur au moins une surface du substrat de sécurité.

25. Article de sécurité (17) selon la revendication 24, dans lequel l'impression sur la surface du substrat de sécurité comprend des indices qui sont identiques aux premiers indices et/ou seconds indices (12, 13) sur l'élément de sécurité (10).

26. Article de sécurité (17) selon l'une quelconque des revendications 24 ou 25 comprenant un billet de banque, un bon, une obligation, un passeport, une étiquette de sécurité, un certificat et similaire.
